# EUROPEAN PATENT SPECIFICATION

(11) **EP 4 550 386 B1**
(45) Date of publication and mention of the grant of the patent: **28.10.2026**
(21) Application number: 23852324.5
(22) Date of filing: 20.07.2023
(51) Int. Cl.: H10P 50/00, H10P 58/00, C09D 129/04

(54) **PROTECTIVE FILM FORMATION AGENT, AND METHOD FOR MANUFACTURING SEMICONDUCTOR CHIP**
SCHUTZSCHICHTBILDUNGSMITTEL UND VERFAHREN ZUR HERSTELLUNG EINES HALBLEITERCHIPS
AGENT DE FORMATION DE FILM PROTECTEUR ET PROCÉDÉ DE FABRICATION DE PUCE À SEMI-CONDUCTEUR

(30) Priority: 08.08.2022 JP 2022126205
(43) Date of publication of application: 07.05.2025
(73) Proprietor: TOKYO OHKA KOGYO CO., LTD., Kawasaki-shi, Kanagawa 211 0012 (JP)
(72) Inventor: MANIWA, Hitomi, Kawasaki-shi, Kanagawa 211-0012 (JP); KINOSHITA, Tetsuro, Kawasaki-shi, Kanagawa 211-0012 (JP)
(74) Representative: Plasseraud IP
(86) International application number: PCT/JP2023/026547
(87) International publication number: WO 2024/034345

(56) References cited:
- WO-A1-2022/153858
- WO-A1-2022/153858
- CN-A- 104 744 987
- CN-A- 104 744 987
- JP-A- 2014 172 932
- JP-A- 2018 174 310
- JP-A- 2018 174 310
- JP-A- 2022 112 001
- JP-A- 2023 041 313

## Description

### TECHNICAL FIELD

The present invention relates to a protective film forming agent and a method of manufacturing a semiconductor chip using this protective film forming agent.

### BACKGROUND ART

A wafer formed in a semiconductor device manufacturing step has a laminate in which an insulating film and a functional film are laminated on the surface of a semiconductor substrate such as silicon, and is demarcated by a lattice of scheduled division lines called streets, and the respective regions demarcated by the streets define semiconductor chips such as IC and LSI.

A plurality of semiconductor chips are obtained by cutting the wafer along these streets. In addition, an optical device wafer has a laminate in which a gallium nitride-based compound semiconductor or the like is laminated, and is demarcated into a plurality of regions by the streets. By cutting along these streets, the optical device wafer is divided into optical devices such as light emitting diodes or laser diodes. These optical devices are widely applied to electrical equipment.

Such cutting along the streets of a wafer has been carried out in the past by a cutting device called a dicer. However, since a wafer having a laminate structure is a highly brittle material, this method has had a problem in that at the time of cutting to divide the wafer into semiconductor chips or the like by a cutting blade (cutting edge), scratches, chips, or the like may occur, causing the insulating film required as a circuit element formed on the chip surface to peel.

In order to avoid such flaws, the following method has been proposed in which a mask containing a layer of water-soluble material is formed on the surface of a semiconductor substrate, and next, the mask is irradiated with a laser to decompose and remove a part of the mask, whereby the surface of the semiconductor substrate is exposed at parts of the mask, and subsequently, the semiconductor substrate exposed from the parts of the mask is cut by plasma etching to divide the semiconductor substrate into semiconductor chips (IC) (see Patent Document 1).

Each one of Patent Documents 2-4 further discloses a protective film forming agent and a method of manufacturing a semiconductor chip using said protective film forming agent.

### Citation List

### Patent Document

Patent Document 1: Japanese Unexamined Patent Application (Translation of PCT Application), Publication No. 2014-523112
Patent Document 2: WO 2022/153858 A1
Patent Document 3: CN 104 744 987 A
Patent Document 4: JP 2018 174310 A

### DISCLOSURE OF THE INVENTION

### Problems to be Solved by the Invention

In this manner, the mask is irradiated with a laser to decompose and remove a part of the mask, whereby a surface of the semiconductor substrate is exposed in the part of the mask, to form a processed groove with a pattern according to a shape of the semiconductor chip. However, when the protective film as a mask is formed using a conventional water-soluble material such as the water-soluble material described in Patent Document 1, there is a problem that the processed groove formed by laser irradiation has poor straightness (straightness of side walls that constitute the processed groove of the protective film) and/or a cross-section of the processed groove has poor rectangularity (rectangularity of a cross-section of the protective film that constitutes the processed groove), that is, laser processability is poor. If the processed groove has poor straightness, semiconductor chips obtained by cutting the semiconductor substrate by plasma etching or the like have poor straightness in the cross-section. Poor rectangularity of the cross-section of the processed groove makes it difficult to cut the semiconductor substrate at a desired position by plasma etching or other methods.

When a protective film is formed using a conventional water-soluble material such as the water-soluble material disclosed in Patent Document 1, there is a problem that cracks may occur. When the protective film is thick, cracks are particularly likely to occur.

The present invention has been made in view of the above problems, and an object of the present invention is to provide a protective film forming agent for use in forming a protective film on a surface of a semiconductor wafer in dicing the semiconductor wafer, in which the protective film forming agent can form a protective film having excellent laser processability and reduced occurrence of cracks, and a method of manufacturing a semiconductor chip using the protective film forming agent.

### Means for Solving the Problems

The present inventors have found that the above problems can be solved by using a protective film forming agent including a water-soluble resin (A), a light absorbing agent (B), at least one plasticizer (C) selected from monosaccharides or disaccharides, and a solvent (S), thereby arriving at completion of the present invention. More specifically, the present invention provides the following.
[1] A protective film forming agent for use in forming a protective film on a surface of a semiconductor wafer in dicing the semiconductor wafer,
   the protective film forming agent including a water-soluble resin (A), a light absorbing agent (B), at least one plasticizer (C) selected from monosaccharides or disaccharides, and a solvent (S).
[2] The protective film forming agent as described in [1], in which the water-soluble resin (A) includes a water-soluble resin (A1) having an aromatic ring and a water-soluble group.
[3] The protective film forming agent as described in [2], in which a content of the plasticizer (C) is 20 parts by mass or more and 100 parts by mass or less with respect to 100 parts by mass of the water-soluble resin (A1).
[4] The protective film forming agent as described in [2] or [3], in which the water-soluble resin (A1) includes a resin having a phenolic hydroxyl group.
[5] The protective film forming agent as described in any one of [1] to [4], in which the water-soluble resin (A) includes a polyvinyl alcohol-based resin.
[6] The protective film forming agent as described in any one of [1] to [5], in which the solvent (S) contains water.
[7] A method of manufacturing a semiconductor chip by processing a semiconductor wafer, the method including, applying the protective film forming agent as described in any one of [1] to [6] to the semiconductor wafer to form a protective film,
   irradiating a predetermined position of one or more layers including the protective film on the semiconductor wafer with a laser light to expose a surface of the semiconductor wafer and to form a processed groove having a pattern corresponding to a shape of the semiconductor chip.
[8] The method of manufacturing the semiconductor chip as described in [7], further including cutting the semiconductor wafer at a position of the processed groove.

### Effects of the Invention

According to the present invention, it is possible to provide a protective film forming agent for use in forming a protective film on a surface of a semiconductor wafer in a method of manufacturing a semiconductor chip from a semiconductor wafer, in which the protective film forming agent can form a protective film having excellent laser processability and reduced occurrence of cracks, and a method of manufacturing a semiconductor chip using the protective film forming agent.

### BRIEF DESCRIPTION OF THE DRAWINGS

FIG. 1 is a perspective view showing a semiconductor wafer processed by a method of processing a wafer using the protective film forming agent of the present invention;
FIG. 2 is an enlarged cross-sectional view of the semiconductor wafer shown in FIG. 1;
FIG. 3 is an enlarged cross-sectional view of a main part of a semiconductor wafer on which a protective film has been formed;
FIG. 4 is a perspective view showing a state in which a semiconductor wafer on which the protective film has been formed is supported by an annular frame via protective tape;
FIG. 5 is a perspective view of a main part of a laser processing device by which a step of laser beam irradiation is conducted;
FIG. 6 is an enlarged cross-sectional view of a semiconductor wafer including a protective film and a processed groove formed by laser beam irradiation;
FIG. 7 is an explanatory view showing plasma irradiation on the semiconductor wafer shown in FIG. 6;
FIG. 8 is an enlarged cross-sectional view showing a state in which a semiconductor wafer is divided into semiconductor chips by plasma irradiation;
FIG. 9 is an enlarged cross-sectional view showing a state in which a protective film on a semiconductor chip has been removed, and
FIG. 10 is a cross-sectional view illustrating a method of evaluating cross-section rectangularity.

### PREFERRED MODE FOR CARRYING OUT THE INVENTION

### <<Protective Film Forming Agent>>

The protective film forming agent is used for forming a protective film on a surface of a semiconductor wafer in dicing the semiconductor wafer. The protective film forming agent includes a water-soluble resin (A), a light absorbing agent (B), at least one plasticizer (C) selected from monosaccharides or disaccharides, and a solvent (S).

Specifically, the protective film forming agent is suitably used to form a protective film in a method for manufacturing a semiconductor chip, the method including: irradiating a protective film formed on a semiconductor wafer with a laser beam to expose the surface of the semiconductor wafer, and to form a processed groove of a pattern according to the shape of the semiconductor chip; and
processing the semiconductor wafer at the position of the processed groove. After the processed groove is formed, the semiconductor chip can be manufactured by cutting the semiconductor wafer at the position of the processed groove.

Because the removal of the protective film is easy by water washing after processing the semiconductor wafer, and, when performing plasma irradiation in a method of manufacturing a semiconductor chip described later, the durability of the protective film on plasma irradiation is sufficient, typically the thickness of the protective film is preferably 0.1 µm or more and 100 µm or less, and more preferably 1 µm or more and 100 µm or less. In the case of laser irradiation, the thickness of the protective film is preferably 0.1 µm or more and 30 um or less.

Hereinafter, essential or optional components contained in the protective film forming agent will be explained.

### <Water-Soluble Resin (A)>

The water-soluble resin (A) is a base material of the protective film formed using the protective film forming agent. The water-soluble resin (A) is a resin which can be dissolved in a solvent such as water and coated or dried to form a film. A resin that can be made water-soluble by hydrolysis or treatment with a base in an aqueous medium also corresponds to the water-soluble resin (A). Examples of such a resin include a resin having a carboxylic anhydride group and a resin having a phenolic hydroxyl group. The carboxylic anhydride group generates carboxy groups or a carboxylic acid salt group by hydrolysis or a treatment with a base in an aqueous medium, to become water-soluble. A resin having a phenolic hydroxyl group is either water-soluble or sparingly water-soluble, depending on its structure. When a resin having a phenolic hydroxyl group is sparingly water-soluble, the resin can be made water-soluble by treating the resin in a basic aqueous medium and converting the phenolic hydroxyl group into a salt (phenolate). Being water-soluble means that 0.5 g or more of a solute (water-soluble resin) is dissolved in 100 g of water or an alkali aqueous solution at 25°C.

The water-soluble resin (A) preferably includes a water-soluble resin (A1) which is a water-soluble resin having an aromatic ring and a water-soluble group. By including the water-soluble resin (A1) having an aromatic ring and a water-soluble group, the protective film to be formed is more excellent in laser processability and also excellent in durability to plasma irradiation when plasma irradiation is performed. The aromatic ring included in the water-soluble resin (A1) may be an aromatic hydrocarbon ring or an aromatic heterocyclic ring. The aromatic ring may have a monocyclic structure or a polycyclic structure. The polycyclic structure may be a polycyclic structure in which two or more monocyclic rings are fused or a polycyclic structure in which two or more rings are bonded to each other via a single bond or linking group. Examples of the aromatic ring having a monocyclic structure include a benzene ring. Examples of the aromatic ring having a polycyclic structure include a naphthalene ring, a biphenyl ring, an anthracene ring, and a phenanthrene ring.

The water-soluble group included in the water-soluble resin (A1) is not particularly limited as long as it is a group capable of imparting water solubility to resins. Examples of the water-soluble group include -SO₃⁻X⁺ (X⁺ is an alkali metal cation, a proton, or N⁺R₄), -COO⁻X⁺ (X⁺ is as described above), a carboxylic anhydride group (-CO-O-CO-), a hydroxy group, and an ether bond (-O-). The carboxylic anhydride group (-CO-O-CO-) is a group that gives -COO⁻X⁺ by hydrolysis or treatment with a base in water. When the hydroxy group is a phenolic hydroxy group, the hydroxy group may form a salt such as an alkali metal salt. It should be noted that R represents a hydrogen atom, an alkyl group, or a hydroxyalkyl group. Examples of the alkali metal include sodium, potassium and strontium.

Examples of the water-soluble resin (A1) include a resin having a phenolic hydroxy group. The phenolic hydroxyl group means a hydroxy group (OH) directly bonded to a carbon atom in the aromatic ring. Examples of the resin having a phenolic hydroxy group include phenolic resins (resins formed of phenols and formaldehydes as raw materials). Examples of the phenol resins as the water-soluble resin (A1) include resins having a structural unit (constituent unit) represented by the following formula (1). 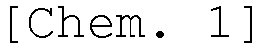 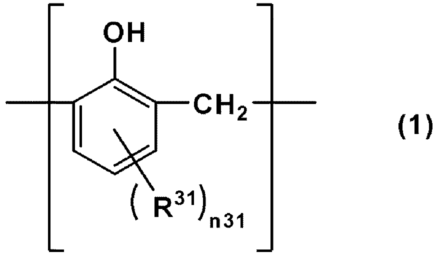 (In the formula (1), R³¹ represents a water-soluble group; and n31 is an integer of 0 to 3.)
As described above, examples of the water-soluble group include -SO₃⁻X⁺ (X⁺ is an alkali metal cation, a proton, or N⁺R₄), -COO⁻X⁺ (X⁺ is as described above), a hydroxy group, and an ether bond (-O-). When the hydroxy group is a phenolic hydroxy group, the hydroxy group may form a salt such as an alkali metal salt. n31 is preferably 1. The substitution position of R³¹ in the benzene ring may be any of an ortho position, a meta position, and a para position with respect to OH in the benzene ring.

Specific examples of the phenol resins as the water-soluble resin (A1) include a phenol resin having a structural unit represented by the following formula (1-1), a phenol resin having a structural unit represented by the following formula (1-2), and a phenol resin having a structural unit represented by the following formula (1-1) and a structural unit represented by the following formula (1-2). With regard to the phenol resin having a structural unit represented by the formula (1-1) and a structural unit represented by the formula (1-2), a proportion of the number of moles of the structural unit represented by the formula (1-1) to the total number of moles of the structural unit represented by the formula (1-1) and moles of the structural unit represented by the formula (1-2) is preferably 0.1 to 0.9, and more preferably 0.7 to 0.9. 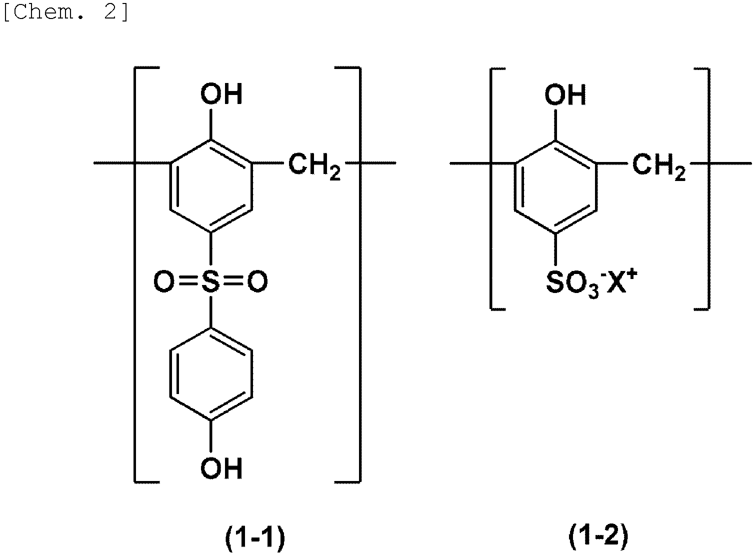 (In the formula, X⁺ represents an alkali metal cation or N⁺R₄, and R represents a hydrogen atom, an alkyl group, or a hydroxyalkyl group.)

Examples the water-soluble resin (A1) also include a styrene-based unit-containing resin, such as a resin having a structural unit represented by the following formula (2). The styrene-based unit is a structural unit derived from styrene or a styrene derivative having a substituent at the α-position or on the benzene ring. 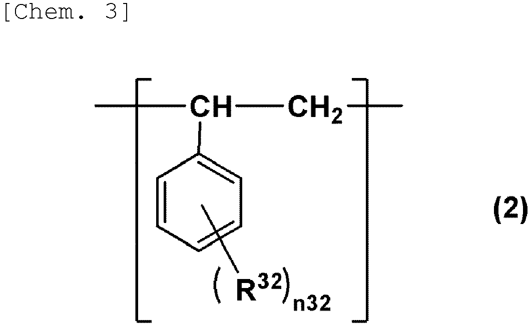 (In the formula (2), R³² represents a water-soluble group; and n32 is an integer of 0 to 3.)
As described above, examples of the water-soluble group include -SO₃⁻X⁺ (X⁺ is an alkali metal cation, a proton, or N⁺R₄), -COO⁻X⁺ (X⁺ is as described above), a hydroxy group, and an ether bond (-O-). When the hydroxy group is a phenolic hydroxy group, the hydroxy group may form a salt such as an alkali metal salt. n32 is preferably 1. The substitution position of R³² in the benzene ring may be any of an ortho position, a meta position, and a para position. As the water-soluble resin (A1), a solution of a resin having a structural unit represented by the formula (2) may be used by neutralizing it with ammonia.

Examples of the resin having a structural unit represented by the formula (2) as the water-soluble resin (A1) include a resin having a structural unit represented by the following formula (2-1), and a resin having a structural unit represented by the following formula (2-1) and a structural unit represented by the following formula (2-2). 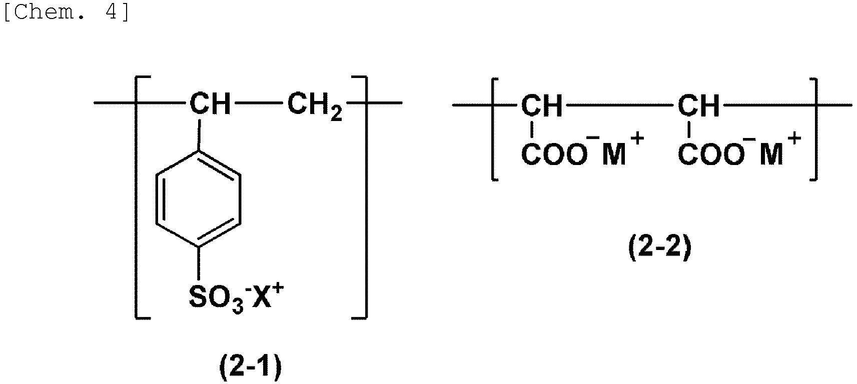 (In the formula, X⁺ is an alkali metal cation, a proton, or N⁺R₄, and R is a hydrogen atom, an alkyl group, or a hydroxyalkyl group;
M⁺ is an alkali metal cation, a proton, or N⁺R⁰¹₄, and R⁰¹ is a hydrogen atom, an alkyl group, or a hydroxyalkyl group; and Examples of the alkali metal include sodium, potassium and strontium.)

Examples of the water-soluble resin (A1) also include a copolymer of styrene and maleic anhydride. The styrene maleic anhydride copolymer is a resin having a structural unit represented by the following formula (3-1) and a structural unit represented by the following formula (3-2). The styrenemaleic anhydride copolymer is a styrene-based unit-containing resin.

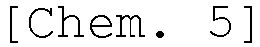

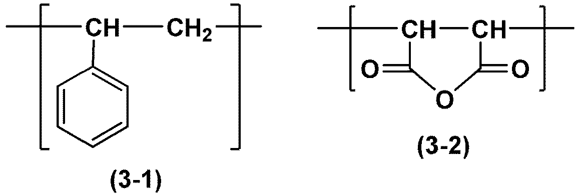

The mass average molecular weight of the water-soluble resin (A1) is preferably 100 or more and 300,000 or less, more preferably 500 or more and 200,000 or less, and most preferably 1,000 or more and 200,000 or less. In the present specification, the mass average molecular weight is a molecular weight in terms of polystyrene measured by GPC.

The content of the water-soluble resin (A1) in the total solid content of the protective film forming agent is preferably 1% by mass or more and 99% by mass or less, more preferably 30% by mass or more and 70% by mass or less, and most preferably 40% by mass or more and 60% by mass or less from the viewpoint of film-forming property. In the present specification, the solid content is a component other than the solvent (S). When the protective film forming agent contains a component which is other than the solvent (S) and which is liquid at a temperature at which the protective film forming agent is used, the liquid component is included in the solid content for convenience.

The water-soluble resin (A) may contain a water-soluble resin other than the water-soluble resin (A1). When the water-soluble resin (A) contains the water-soluble resin (A1) and a water-soluble resin other than the water-soluble resin (A1), a ratio of the mass of the water-soluble resin (A1) to the mass of the water-soluble resin (A) is, for example, 30% by mass or more and less than 100% by mass, preferably 40% by mass or more and 85% by mass or less, and more preferably 50% by mass or more and 80% by mass or less. Examples of the water-soluble resin other than the water-soluble resin (A1) (hereinafter also referred to as "other water-soluble resins") include vinyl-based resins, cellulose-based resins, polyethylene oxide, polyglycerin, and water-soluble nylon. The vinyl resin-based is not particularly limited so long as being a homopolymer or copolymer of a monomer having a vinyl group, and being a water-soluble resin. Examples of the vinyl-based resin include polyvinyl alcohol-based resins. Examples of the polyvinyl-based resin include polyvinyl alcohol, polyvinyl acetal (also including a vinyl acetate copolymer), a butene diol-vinyl alcohol copolymer, a polyvinyl alcohol polyacrylic acid block copolymer, and a polyvinyl alcohol polyacrylic acid ester block copolymer. Examples of the vinyl-based resin also include polyvinylpyrrolidone, polyacrylamide, poly(N-alkylacrylamide), polyallylamine, poly(N-alkylallylamine), partially amidated polyallylamine, poly(diallylamine), allylamine-diallylamine copolymer, and polyacrylic acid. The cellulose-based resin is not particularly limited so long as being a water-soluble cellulose derivative. Examples of the cellulose-based resin include methyl cellulose, ethyl cellulose, hydroxypropyl cellulose, and the like. These can be used individually, or two or more of these can be used in combination. When the water-soluble resin (A) contains the water-soluble resin (A1) and the cellulose-based resin, a ratio of a mass of the water-soluble resin (A1) to a mass of the water-soluble resin (A) is preferably 60% by mass or more and 85% by mass or less, and more preferably 65% by mass or more and 80% by mass or less.

Among examples of the other water-soluble resins, vinyl-based resins and cellulose-based resins are preferable, and polyvinylpyrrolidone and hydroxypropyl cellulose are more preferable, because deterioration of the shape of the processed groove due to heat sag property of the protective film is less likely to occur. From the viewpoint of film-forming property, the cellulose-based resin is preferable.

The protective film formed on the semiconductor wafer surface normally is removed from the surface of the semiconductor wafer or semiconductor chip, at the appropriate moment after formation of the processed groove, according to the method of processing a semiconductor wafer including the protective film and processed groove into semiconductor chips. For this reason, a water-soluble resin having low affinity for the semiconductor wafer surface is preferable from the viewpoint of water washability of the protective film. The water-soluble resin having low affinity for the semiconductor wafer surface is preferably a resin having only an ether bond, hydroxy group, or amide bond as polar groups, for example, polyvinyl alcohol, polyethylene glycol, polyvinylpyrrolidone, and hydroxypropyl cellulose.

The other water-soluble resins preferably have a mass average molecular weight of preferably 5,000 or more and 300,000 or less, and more preferably 10,000 or more and 200,000 or less.

Since opening defects upon forming the processed groove by irradiating the protective film with a laser beam, shape deterioration of the processed groove due to heat sagging of the protective film, etc. hardly occur, the ratio of the mass of water-soluble resin (A) relative to the sum of the mass of water-soluble resin (A) and mass of light absorbing agent (B) in the protective film forming agent is preferably 60% by mass or more and 99% by mass or less, and more preferably 80% by mass or more and 95% by mass or less.

### <Light Absorbing Agent (B)>

As the light absorbing agent (B), light absorbing agents generally used for protective film forming agents can be used. As the light absorbing agent (B), it is preferred to use a water-soluble dye, a water-soluble colorant, and a water-soluble light absorbing agent such as a water-soluble ultraviolet absorbing agent. The water-soluble light absorbing agent exists evenly in the protective film and is thus advantageous. Examples of the water-soluble light absorbing agent can include organic acids having a carboxy group or a sulfo group; sodium salts, potassium salts, ammonium salts, and quaternary ammonium salts of organic acids; and compounds having a hydroxy group. In the case of using a water-soluble light absorbing agent, the storage stability of the protective film forming agent is high, and flaws such as phase separation of the protective film forming agent and precipitation of the light absorbing agent are thus suppressed during storage of the protective film forming agent. Therefore, it is advantageous also from the viewpoint of easily maintaining favorable coatability of the protective film forming agent for a long period.

It should be noted that a water-insoluble light absorbing agent such as a pigment can also be used. In the case of using a water-insoluble light absorbing agent, although fatal obstacles to use of the protective film forming agent do not arise, variation in the laser-absorbing ability of the protective film may arise, it may be difficult to obtain a protective film forming agent having excellent storage stability and coatability, and it may be difficult to form a protective film of uniform thickness.

Examples of the light absorbing agent (B) can include a benzophenone-based compound, a cinnamic acid-based compound, an anthraquinone-based compound, a naphthalene-based compound, and a biphenyl-based compound. Examples of the benzophenone-based compound include a compound represented by the following formula (B1). The compound represented by the following formula (B1) is preferred because it is capable of efficiently absorbing the energy of a laser beam in the protective film, and promoting the thermal decomposition of the protective film. 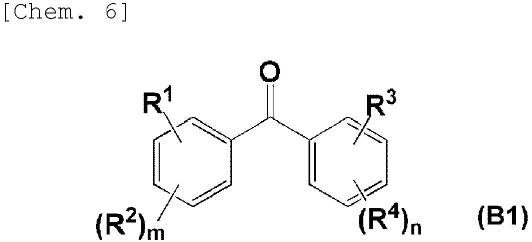 (in the formula (B1), R¹ and R³ are each independently a hydroxy group or a carboxy group, R² and R⁴ are each independently a hydroxy group, a carboxy group or a group represented by -NR⁵R⁶, R⁵ and R⁶ are each independently a hydrogen atom or an alkyl group having 1 or more and 4 or less carbon atoms, and m and n are each independently an integer of 0 or more and 2 or less.)

The compound represented by the above formula (B1) has a high absorbance index, and exhibits a high absorbance index even in the case of being added to the protective film forming agent together with an alkali. For this reason, when forming a protective film using the protective film forming agent containing a compound represented by the above formula (B1) as the light absorbing agent (B), it is possible to favorably perform partial decomposition of the protective film by laser when forming a mask for dicing.

In the above formula (B1), R² and R⁴ may be a group represented by -NR⁵R⁶. R⁵ and R⁶ are each independently a hydrogen atom or an alkyl group having 1 or more and 4 or less carbon atoms. The alkyl group as R⁵ and R⁶ may be a straight chain or a branched chain. Specific examples of the alkyl group as R⁵ and R⁶ include a methyl group, an ethyl group, a n-propyl group, an isopropyl group, a n-butyl group, an isobutyl group, a sec-butyl group and a tert-butyl group.

As the group represented by -NR⁵R⁶, an amino group, a methylamino group, an ethylamino group, a dimethylamino group and a diethylamino group are preferable, and an amino group, a dimethylamino group and a diethylamino group are more preferable.

The compound represented by the formula (B1) is preferably a compound represented by the following formula (B1-1) due to a high absorbance index in the presence of a base: 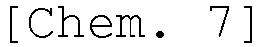 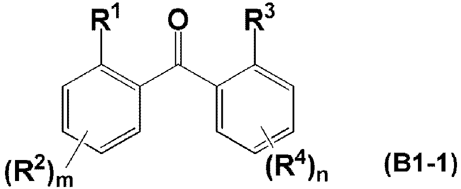 (in the formula (B1-1), R¹ to R⁴, m and n are the same as those in the formula (B1)).

In the above formula (B1) and formula (B1-1), at least one of R¹ or R³ is preferably a hydroxy group due to a high absorbance index in the presence of a base.

The compound represented by the formula (B1-1) is preferably a compound represented by any of the following formulae (B1-1a) to (B1-1e): 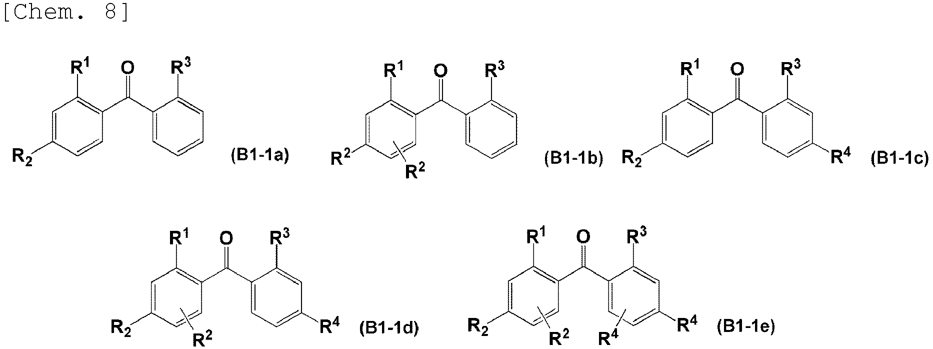 (in the formula (B1-1a) to the formula (B1-1e), R¹ to R⁴ are the same as those in the formula (B1)).

Among the compounds represented by the formula (B1-1a) to the formula (B1-1e), a compound represented by the formula (B1-1a) is preferred. In the compounds represented by the formula (B1-1a) to the formula (B1-1e), preferred are those wherein R² is the aforementioned group represented by -NR⁵R⁶, and R⁵ and R⁶ are each independently an alkyl group having 1 or more and 4 or less carbon atoms.

Suitable specific examples of the compound represented by the formula (B1) include the following compounds. These compounds are preferable due to ease of availability, and a high absorbance index even in the presence of a base.

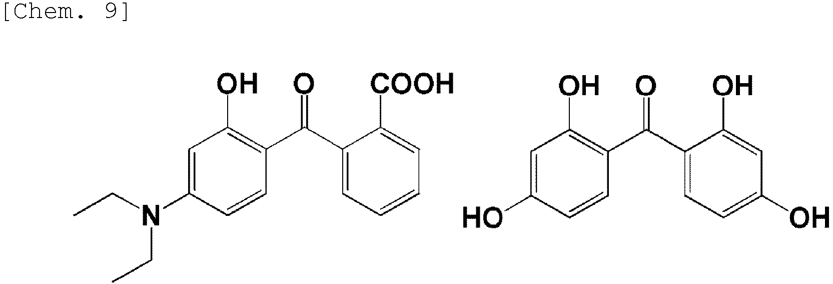

When the light absorbing agent (B) contains a compound represented by the formula (B1), a proportion of the mass of the compound represented by the formula (B1) relative to the mass of the light absorbing agent (B) is not particularly limited within the range where the object of the present invention is not impaired. The proportion of the mass of the compound represented by the formula (B1) relative to the mass of light absorbing agent (B) is preferably 70% by mass or more, more preferably 80% by mass or more, further preferably 95% by mass or more, and particularly preferably 100% by mass.

Examples of the benzophenone-based compound can also include 4,4'-dicarboxybenzophenone, benzophenone-4-carboxylic acid, and tetrahydroxybenzophenone. These are all water-soluble ultraviolet absorbing agents.

Examples of the cinnamic acid-based compound include a compound represented by the following formula (B2). The compound represented by the following formula (B2) is preferred because it is capable of efficiently absorbing the energy of a laser beam in the protective film, and promoting the thermal decomposition of the protective film. 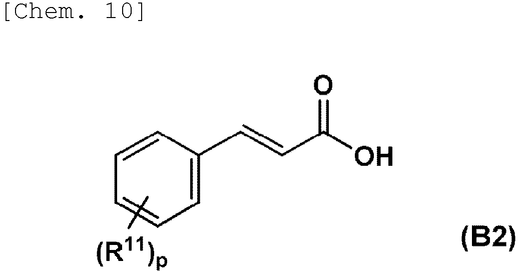 (in the formula (B2), R¹¹ is a hydroxy group, an alkoxy group or a group represented by -NR¹²R¹³, R¹² and R¹³ are each independently a hydrogen atom or an alkyl group having 1 or more and 4 or less carbon atoms, p is an integer of 0 or more and 3 or less, and when p is 2 or more, a plurality of R¹¹s may be the same or different).

In the above the formula (B2), the alkoxy group as R¹¹ may be a straight chain or a branched chain. The alkoxy group as R¹¹ is preferably an alkoxy group having 1 or more and 4 or less carbon atoms. Specific examples of the alkoxy group as R¹¹ is a methoxy group, an ethoxy group, a n-propoxy group, an isopropoxy group, and a n-butoxy group.

In the above formula (B2), R¹¹ may be a group represented by -NR¹²R¹³. R¹² and R¹³ are each independently a hydrogen atom or an alkyl group having 1 or more and 4 or less carbon atoms. The alkyl group as R¹² and R¹³ may be a straight chain or a branched chain. Specific examples of the alkyl group as R¹² and R¹³ include a methyl group, an ethyl group, a n-propyl group, an isopropyl group, a n-butyl group, an isobutyl group, a sec-butyl group and a tert-butyl group.

The compound represented by the formula (B2) is preferably a compound represented by the following the formula (B2-1). 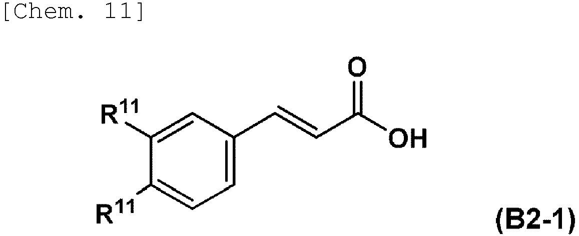 (in the formula (B2-1), R¹¹ is the same as R¹¹ in the formula (B2)).

Specific examples of the cinnamic acid-based compound can include 4-aminocinnamic acid, 3-aminocinnamic acid, 2-aminocinnamic acid, sinapic acid (3,5-dimethoxy-4-hydroxycinnamic acid), ferulic acid, and caffeine acid. Among these, 4-aminocinnamic acid, 3-aminocinnamic acid, 2-aminocinnamic acid and ferulic acid are preferable, 4-aminocinnamic acid and ferulic acid are more preferable, and 4-aminocinnamic acid is particularly preferable.

Specific examples of the anthraquinone-based compound can include 2-carboxyanthraquinone, 2,6-anthraquinone disulfonic acid, and 2,7-anthraquinone disulfonic acid, and the like.

Specific examples of the naphthalene-based compound can include 1,2-naphthalenedicarboxylic acid, 1,8-naphthalenedicarboxylic acid, 2,3-naphthalenedicarboxylic acid, 2,6-naphthalenedicarboxylic acid, and 2,7-naphthalenedicarboxylic acid, and the like.

Specific examples of the biphenyl-based compound can include biphenyl-4-sulfonic acid, and the like.

Examples of the light absorbing agent (B) can also include water-soluble amines such as curcumin, and EAB-F (4,4'-bis(diethylamino) benzophenone).

As specific examples of the water-soluble dye, a water-soluble dye is selected from among azo dyes (monoazo and polyazo dyes, metal complex azo dyes, pyrazolone azo dyes, stilbene azo dyes, thiazole azo dyes), anthraquinone dyes (anthraquinone derivatives, anthrone derivatives), indigoid dyes (indigoid derivatives, thioindigoide derivatives), phthalocyanine dyes, carbonium dyes (diphenylmethane dyes, triphenylmethane dyes, xanthene dyes, acridine dyes), quinone imine dyes (azine dyes, oxazine dyes, thiazine dyes), methine dyes (cyanine dyes, azomethine dyes), quinoline dyes, nitroso dyes, benzoquinone and naphthoquinone dyes, naphthalimide dyes, perinone dyes and other dyes.

As the water-soluble colorant, for example, colorants for food additives such as Food Red No. 2, Food Red No. 40, Food Red No. 102, Food Red No. 104, Food Red No. 105, Food Red No. 106, Food Yellow NY, Food Yellow No. 4 tartrazine, Food Yellow No. 5, Food Yellow No. 5 Sunset Yellow FCF, Food Orange AM, Food Vermillion No. 1, Food Vermillion No. 4, Food Vermillion No. 101, Food Blue No. 1, Food Blue No. 2, Food Green No. 3, Food Melon Color B, and Food Egg Color No. 3 are suitable from the viewpoint of low environmental load, etc.

The amount of the light absorbing agent (B) in the protective film forming agent is not particularly limited without impairing the object of the present invention. The amount of the light absorbing agent (B) in the protective film forming agent is preferably 0.1% by mass or more and 20% by mass or less, and more preferably 5% by mass or more and 15% by mass or less with respect to the total solid content of the protective film forming agent. Since opening defects upon forming the processed groove by irradiating the protective film with a laser beam, shape deterioration of the processed groove due to heat sagging of the protective film, etc. hardly occur, the ratio of the mass of light absorbing agent (B) relative to the sum of the mass of water-soluble resin (A) and mass of light absorbing agent (B) in the protective film forming agent is preferably 0.1% by mass or more and 50% by mass or less, more preferably 1% by mass or more and 40% by mass or less, and further preferably 2.5% by mass or more and 20% by mass or less. The amount of the light absorbing agent (B) can be set so that the absorbance of the protective film formed by coating the protective film forming agent will have a desired value. The absorbance of the protective film formed by coating the protective film forming agent is not particularly limited, and the absorbance of the protective film formed by coating the protective film forming agent is for example preferably 0.3 or more, more preferably 0.8 or more and further preferably 1.0 or more per 1 µm thickness at a wavelength of 355 nm.

### <Plasticizer (C)>

The plasticizer (C) is at least one selected from monosaccharides or disaccharides. In the present specification, the plasticizer is a substance capable of imparting flexibility or elasticity to a protective film formed using the protective film forming agent.

Examples of the monosaccharides include aldose (monosaccharides having a formyl group), ketose (monosaccharides having a carbonyl group), and derivatives thereof. The derivatives include aldonic acid (carboxylic acid in which a formyl group at 1-position of aldose has been converted to a carboxy group), uronic acid (carboxylic acid in which a hydroxymethyl group at the terminal of main chain of monosaccharide has been converted to a carboxy group), and aldaric acid (dicarboxylic acid in which both a formyl group at the 1-position of aldose and a hydroxymethyl group at the terminal of main chain have been changed to carboxyl groups).

Specific examples of aldose include D-glyceraldehyde, D-erythrose, D-threose, D-ribose, D-arabinose, D-xylose, D-lyxose, D-glucose, D-galactose, D-allose, D-altrose, D-mannose, D-gulose, D-idose, and D-talose. Specific examples of the ketose include dihydroxyacetone, D-erythrulose, D-xylulose, D-ribulose, D-fructose, D-psicose, D-sorbose, D-tagatose, and D-sedoheptulose. Specific examples of the derivative include gluconic acid, glucuronic acid, glucaric acid, and inositol.

Examples of disaccharides include disaccharides composed of the above-described monosaccharides described as the monosaccharides. Specific examples of the disaccharide include maltose, sucrose, lactose, lactulose, trehalose, and cellobiose.

Among them, D-ribose, D-xylose, D-glucose, D-galactose, D-fructose, inositol and maltose are preferable, and D-ribose, D-glucose, D-galactose, D-fructose, inositol and maltose are more preferable.

When the protective film forming agent contains at least one plasticizer (C) selected from monosaccharides or disaccharides together with the water-soluble resin (A), the light absorbing agent (B), and the solvent (S), a protective film having excellent laser processability and reduced occurrence of cracks can be formed as shown in Examples described later. Note that, in the present specification, the laser processability means straightness of the processed groove formed by laser irradiation (straightness of side walls that constitute the processed groove of the protective film) and rectangularity of a cross-section of the processed groove (rectangularity of a cross-section of the protective film that constitutes the processed groove).

As described above, it is unclear why the protective film forming agent containing at least one plasticizer (C) selected from monosaccharides or disaccharides together with the water-soluble resin (A), the light absorbing agent (B), and the solvent (S) can form a protective film having excellent laser processability and reduced occurrence of cracks. The reason for this is presumed as follows. First, as described above, the monosaccharide and disaccharide are used as the plasticizer (C). It is considered that the protective film is satisfactorily plasticized by the excellent plasticizing action of the monosaccharide and the disaccharide on the water-soluble resin (A) such as the water-soluble resin (A1), suppressing the occurrence of cracks. In addition, it is considered that monosaccharides and disaccharides as the plasticizer (C) can plasticize the protective film without excessively lowering the heat resistance of the protective film. It is considered that thereby, the laser irradiated portion of the protective film is not excessively softened or fluidized during the laser processing, and as a result, a processed groove having a smooth side surface (side wall) and a rectangular cross-section is formed by laser processing.

On the other hand, when a saccharide (for example, cellulose) which is not a monosaccharide or a disaccharide is used instead of the monosaccharide or the disaccharide, or when a plasticizer (for example, trimethylolpropane, neopentyl glycol, and polyethylene glycol) which is not a saccharide is used instead of the monosaccharide or the disaccharide, a crack occurs in a protective film to be formed, or straightness and/or cross-section rectangularity of a processed groove deteriorates. This is considered to be derived from the fact that when a saccharide having a large molecular weight or a compound having a small number of hydroxy groups in one molecule is used as the plasticizer, the effect of plasticizing is weak, or it is difficult to form a dense network by hydrogen bonding between the plasticizer (C) and the water-soluble resin (A).

In addition, by the film protective film forming agent containing at least one plasticizer (C) selected from monosaccharides or disaccharides together with the water-soluble resin (A), the light absorbing agent (B), and the solvent (S), stickiness (tack) of the formed protective film can be suppressed, whereby a protective film having no stickiness or small stickiness can be obtained.

A content of the at least one plasticizer (C) selected from monosaccharides or disaccharides is preferably 5 parts by mass or more and 100 parts by mass or less, and more preferably 10 parts by mass or more and 80 parts by mass or less with respect to 100 parts by mass of the water-soluble resin (A). The content of the at least one plasticizer (C) selected from monosaccharides or disaccharides is preferably 20 parts by mass or more and 100 parts by mass or less, and more preferably 20 parts by mass or more and 70 parts by mass or less with respect to 100 parts by mass of the water-soluble resin (A1).

### <Other Additives>

The protective film forming agent may contain other additives in addition to the water-soluble resin (A), the light absorbing agent (B), and the plasticizer (C) as long as the object of the present invention is not impaired. As other additives, for example, a basic compound, a preservative, a surfactant, and the like can be used.

### <Basic Compound>

When the protective film forming agent contains the compound represented by the formula (B1), the protective film forming agent may contain a basic compound for the purpose of facilitating dissolution of the compound represented by the formula (B1). As the basic compound, either an inorganic compound or organic compound can be used. As the basic compound, an organic compound is preferable. As specific examples of the basic compound, it is possible to exemplify basic inorganic compounds such as sodium hydroxide, potassium hydroxide, sodium carbonate, potassium carbonate, sodium silicate, sodium metasilicate and ammonia; and basic organic compounds such as ethylamine, n-propylamine, monoethanolamine, diethylamine, di-n-propylamine, diethanolamine, triethylamine, methyldiethylamine, dimethylethanolamine, triethanolamine, tetramethylammonium hydroxide, tetraethylammonium hydroxide, pyrrole, piperidine, 1,8-diazabicyclo(5,4,0)-7-undecene, and 1,5-diazabicyclo(4,3,0)-5-nonane.

The amount used of the basic compound is not particularly limited in a range not inhibiting the object of the present invention. The amount used of the basic compound relative to 1 mol of the compound represented by the formula (B1), is preferably 1 mol or more, and more preferably 1 mol or more and 20 mol or less. The lower limit for the amount used of the basic compound, relative to 1 mol of the compound represented by the formula (B1), may be 1.5 mol or more, may be 2 mol or more, and may be 3 mol or more. The upper limit for the amount used of the basic compound, relative to 1 mol of the compound represented by the formula (B1), may be 15 mol or less, may be 10 mol or less, and may be 5 mol or less.

### (Preservative)

As the preservative, it is possible to use benzoic acid, butylparaben, ethylparaben, methylparaben, propylparaben, sodium benzoate, sodium propionate, benzalkonium chloride, benzethonium chloride, benzyl alcohol, cetylpyridinium chloride, chlorobutanol, phenol, phenylethyl alcohol, 2-phenoxyethanol, phenylmercuric nitrate, thimerosal, metacresol, lauryldimethylamine oxide, and combinations of these.

Using a preservative is preferable not only from the point of preservation of the protective film forming agent, but also the point of a load reduction in the processing of waste liquid after semiconductor wafer washing. A large amount of washing water is generally used for washing of semiconductor wafers. However, in the process using the aforementioned protective film forming agent, proliferation of bacteria in the waste liquid is of concern due to the water-soluble resin (A) contained in the protective film forming agent. For this reason, it is desirable for the waste liquid derived from a process using the aforementioned protective film forming agent to be treated separately from the waste liquid derived from a process not using the protective film forming agent. However, in the case of containing a preservative in the protective film forming agent, since the proliferation of bacteria caused by the water-soluble resin (A) is suppressed, the waste liquid derived from the process using the protective film forming agent and the waste liquid derived from a process not using the protective film forming agent can be treated similarly. For this reason, it is possible to reduce the load of waste-water treatment processing.

### (Surfactant)

The surfactant, for example, is used in order to raise the defoaming property during protective film forming agent production, stability of the protective film forming agent, coatability of the protective film forming agent, etc. In particular, it is preferable to use a surfactant in the point of the defoaming property during protective film forming agent production.

A protective film is generally formed by spin coating the protective film forming agent. However, surface irregularities caused by bubbles may occur upon forming the protective film. In order to suppress the occurrence of such surface irregularities, it is preferable to use an anti-foaming agent such as a surfactant.

As the surfactant, a water-soluble surfactant can be used preferably. As the surfactant, any of nonionic surfactant, cationic surfactant, anionic surfactant and amphoteric surfactant can be used. The surfactant may be silicone based. A nonionic surfactant is preferable from the point of washability.

### <Solvent (S)>

The protective film forming agent contains a solvent (S) for dissolving the water-soluble resin (A), light absorbing agent (B), and at least one plasticizer (C) selected from monosaccharides or disaccharides. As the solvent (S), it is possible to use any of water, organic solvent, and an aqueous solution of organic solvent. In the point of little risk of ignition during use, cost, etc., the solvent (S) preferably contains water. Specifically, the solvent (S) is preferably water and an aqueous solution of organic solvent, and more preferably water.

From the viewpoint of flammability, the amount of the organic solvent in the solvent (S) is preferably 30% by mass or less, more preferably 20% by mass or less, further preferably 15% by mass or less.

The solvent (S) is preferably selected so that the protective film forming agent does not have a flash point under 1 atm of pressure. More specifically, by adjusting the content of water in the protective film forming agent, the flash point of the protective film, or presence/absence of a flash point is adjusted. The protective film forming agent without a flash point is safe, for example, and can be left under a non-explosion proof environment. More specifically, it is possible to carry out handling such as storage, transport and use of the protective film forming agent under a non-explosion proof environment. For example, not only the introduction of the protective film forming agent to the semiconductor factory, but also the formation of the protective film can be carried out under a non-explosion proof environment. Therefore, in the point of an explosion proof environment such as a usually expensive explosion proof equipment being unnecessary, the protective film forming agent without a flash point is very advantageous in industry.

The flash point can be obtained by measuring under 1 atm of pressure by the tag closed cup method at a liquid temperature no higher than 80°C, and measured by the Cleveland open cup method at a liquid temperature exceeding 80°C. In the scope of the disclosure and claims of the present application, a case of the flash point not being measurable even when measuring by the Cleveland open cup method is defined as being without a flash point.

Examples of the organic solvent which can be contained in the protective film forming agent include methyl alcohol, ethyl alcohol, alkylene glycol, alkylene glycol monoalkyl ether, alkylene glycol monoalkyl ether acetate, and the like. Examples of the alkylene glycol include ethylene glycol, propylene glycol, and the like. Examples of the alkylene glycol monoalkyl ether include ethylene glycol monomethyl ether, ethylene glycol monoethyl ether, propylene glycol monomethyl ether, propylene glycol monoethyl ether, and the like. Examples of the alkylene glycol monoalkyl ether acetate include ethylene glycol monomethyl ether acetate, ethylene glycol monoethyl ether acetate, propylene glycol monomethyl ether acetate, propylene glycol monoethyl ether acetate, and the like. The protective film forming agent may contain a combination of two or more types of organic solvent.

The solid content concentration of the protective film forming agent is not particularly limited without impairing the object of the present invention. The solid content concentration, for example, is preferably 5% by mass or more and 60% by mass or less, and more preferably 10% by mass or more and 50% by mass or less.

### <<Method of Manufacturing Semiconductor Chip>>

A method of manufacturing a semiconductor chip is a method including a manufacturing of semiconductor chips by processing semiconductor wafers. More specifically, the method of manufacturing a semiconductor chip is a method including: forming a protective film by coating the semiconductor wafer with the aforementioned protective film forming agent; and irradiating a predetermined position of one or more layers including the protective film on the semiconductor wafer with a laser beam to expose the surface of the semiconductor wafer, and to form a processed groove with a pattern according to a shape of the semiconductor chip. Typically, the above manufacturing method of semiconductor chips includes cutting the position (position corresponding to the position of a street) of a processed groove on the semiconductor wafer. Hereinafter, forming a protective film is also referred to as "protective film forming step", forming a processed groove is also referred to as "processed groove forming step", and cutting the semiconductor wafer at a position of the processed groove is also referred to as "cutting step".

### <Protective Film Forming Step>

In the protective film forming step, a protective film is formed by coating the semiconductor wafer with the aforementioned protective film forming agent.

The shape of a processed surface of the semiconductor wafer is not particularly limited so long as the desired processing can be conducted on the semiconductor wafer. Typically, the processed surface of the semiconductor wafer has many surface irregularities. Then, a recessed part is formed in a region corresponding to a street. In the processed surface of the semiconductor wafer, a plurality of regions corresponding to semiconductor chips are demarcated by the streets. Since the protective film is easily removed by water washing after processing, and the protective film has sufficient durability to plasma irradiation in the case of performing plasma irradiation in the cutting step described later, typically, the thickness of the protective film is preferably 0.1 µm or more and 100 µm or less, and more preferably 1 µm or more and 100 µm or less. In the case of laser irradiation in the processed groove forming step, the thickness of the protective film is preferably 0.1 µm or more and 30 µm or less.

Hereinafter, about a manufacturing method of semiconductor chips, in which using the aforementioned protective film forming agent, dicing processing is performed on a semiconductor wafer including a plurality of semiconductor chips demarcated by a lattice of streets, a preferred aspect of the manufacturing method of semiconductor chips will be explained with reference to the drawings.

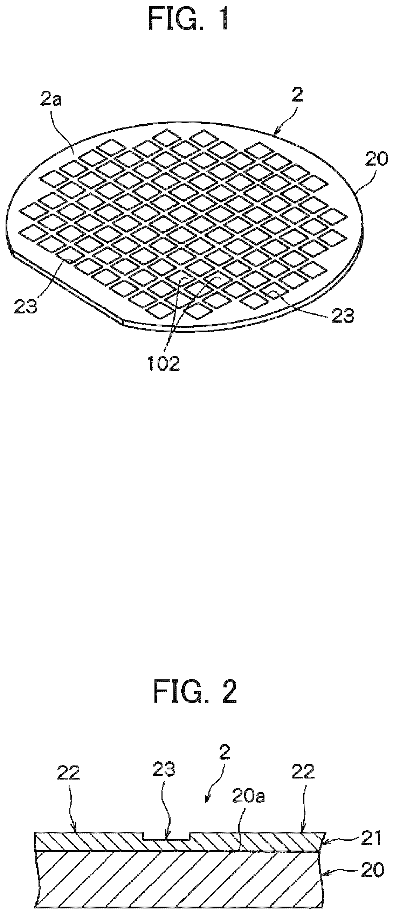

FIG. 1 shows a perspective view of a semiconductor wafer as a processing target. FIG. 2 shows an enlarged cross-sectional view of a main part of the semiconductor wafer shown in FIG. 1. In a semiconductor wafer 2 shown in FIGS. 1 and 2, a laminate 21 in which a functional film forming an insulating film and circuit are laminated is provided on a surface 20a of a semiconductor substrate 20 such as silicon. In the laminate 21, a plurality of semiconductor chips 22 such as IC and LSI are formed in a matrix shape. Herein, the shape and size of the semiconductor chips 22 are not particularly limited, and can be appropriately set according to the design of the semiconductor chip 22.

Each of the semiconductor chips 22 is demarcated by the streets 23 formed in a lattice shape. It should be noted that, in the illustrated embodiment, the insulating film used as the laminate 21 consists of a SiO₂ film, or a low-dielectric constant insulating film (Low-k film) consisting of an inorganic film such as SiOF or BSG (SiOB), or an organic film, which is a polymer film such as of polyimide type or parylene type.

The surface of the above laminate 21 corresponds to the surface 2a which is the processed surface. The protective film is formed on the above surface 2a using the aforementioned protective film forming agent.

In the protective film forming step, for example, the protective film is formed by coating the protective film forming agent on the surface 2a of the semiconductor wafer 2 by a spin coater. It should be noted that the coating method of the protective film forming agent is not particular limited so long as a protective film of a desired thickness can be formed.

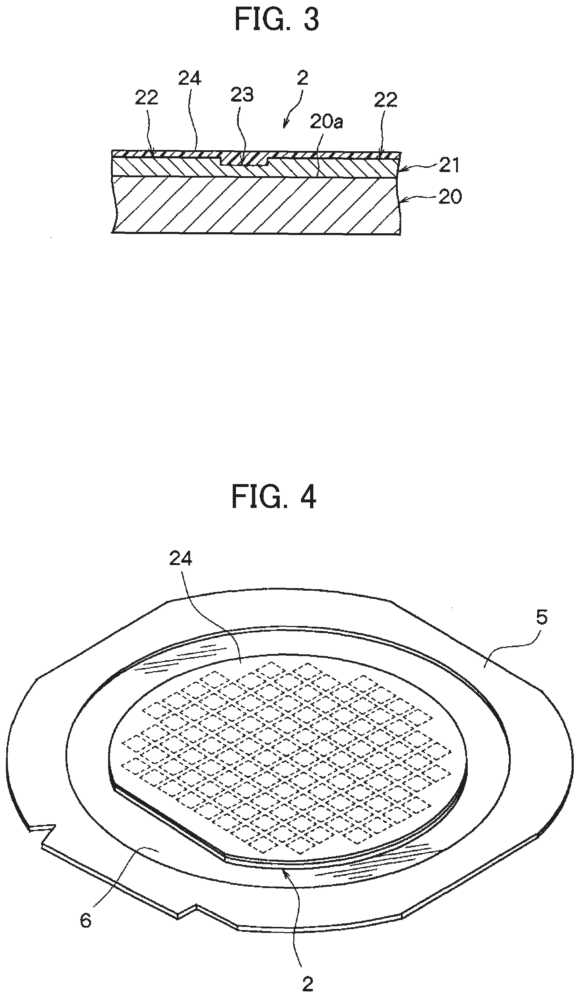

Next, the protective film forming agent in a liquid form coating the surface 2a is dried, as necessary. A protective film 24 is thereby formed on the surface 2a of the semiconductor wafer 2 as shown in FIG. 3. Since the protective film 24 is formed of the above-described protective film forming agent containing at least one plasticizer (C) selected from monosaccharides or disaccharides together with the soluble resin (A), the light absorbing agent (B), and the solvent (S), occurrence of cracks is suppressed, and the protective film 24 having no cracks or few cracks can be formed. In addition, the protective film 24 in which stickiness is suppressed can be formed.

After the protective film 24 is formed on the surface 2a of the semiconductor wafer 2 in this way, protective tape 6 put onto an annular frame 5 is pasted on the back surface of the semiconductor wafer 2, as shown in FIG. 4.

### <Processed Groove Forming Step>

In the processed groove forming step, a predetermined position of one or more layers including the protective film 24 on the semiconductor wafer 2 is irradiated with a laser beam to expose the surface 20a of the semiconductor substrate 20, whereby the processed groove with a pattern according to the shape of the semiconductor chip 22 is formed.

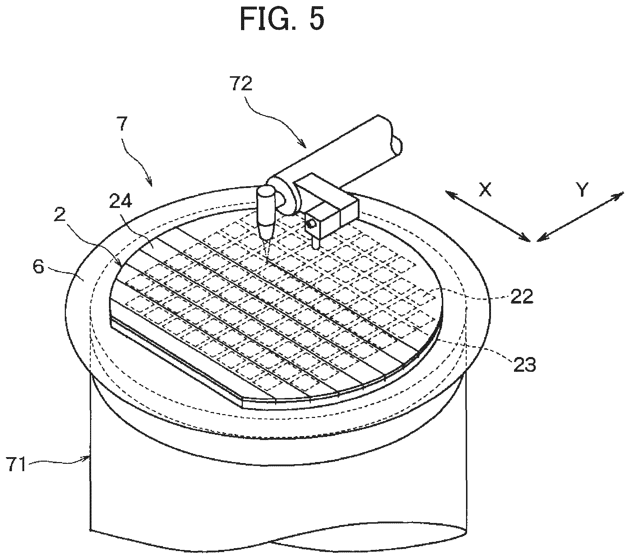

Specifically, the surface 2a (street 23) of the semiconductor wafer 2 is irradiated with a laser beam through the protective film 24. This laser beam irradiation is carried out using a laser beam irradiation means 72 as shown in FIG. 5. The laser is preferably an ultraviolet laser having a wavelength of 100 nm or more and 400 nm or less because of the intensity. In addition, a YVO4 laser and YAG laser with a wavelength of e.g. 266 nm or 355 nm are preferable.

The above laser beam irradiation in the processed groove forming step is performed on the following processing conditions, for example. It should be noted that the light collecting spot diameter is appropriately selected considering the width of a processed groove 25.
Light source of laser beam: YVO4 laser or YAG laser,
Wavelength: 355 nm,
Repetition frequency: 50 kHz or more and 100 kHz or less,
Output: 0.3 W or more and 4.0 W or less,
Process feed rate: 1 mm/s or more and 800 mm/s or less.

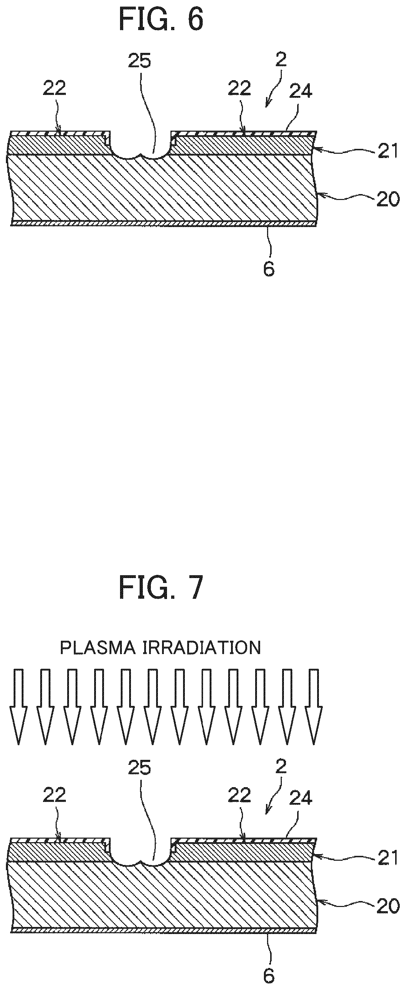

By carrying out the above-described processed groove forming step, the processed groove 25 is formed along the street 23 in the laminate 21 including the street 23 in the semiconductor wafer 2, as shown in FIG. 6. Since the protective film 24 is formed of the above-described protective film forming agent containing at least one plasticizer (C) selected from monosaccharides or disaccharides together with the water-soluble resin (A), the light absorbing agent (B), and the solvent (S), it is possible to form a groove (processed groove 25) excellent in straightness and cross-section rectangularity in the protective film 24 by irradiating the protective film 24 with laser light as described above.

Laser beam irradiation along predetermined streets 23 is carried out as described above, and the semiconductor wafer 2 retained on a chuck table 71 is then indexed by intervals of the streets in the direction indicated by the arrow Y, and laser beam irradiation is carried out again.

After laser beam irradiation and indexing along all the streets 23 extending in a predetermined direction as described above, the semiconductor wafer 2 retained on the chuck table 71 is rotated by 90 degrees, and the laser beam irradiation and indexing are carried out in the same manner as above along each street 23 extending at a right angle relative to the above predetermined direction. In this way, it is possible to form the processed grooves 25 along all the streets 23 formed in the laminate 21 on the semiconductor wafer 2.

### <Cutting Step>

In the cutting step, the semiconductor wafer 2 having the processed groove 25 at a position corresponding to the position of the street 23 is cut. Examples of the cutting method include a method of cutting the semiconductor wafer 2 provided with the protective film 24 or the semiconductor wafer 2 from which the protective film 24 has been peeled off, by blade, and a method of irradiating the semiconductor wafer 2 provided with the protective film 24 and the processed groove 25 with a laser or a plasma to cut the semiconductor wafer 2. When cutting the semiconductor wafer 2 by blade, for example, the semiconductor wafer 2 is cut by blade along the position of the processed groove 25 while supplying pure water to the cutting position. When radiating a laser, the laser is radiated to the processed groove 25 so as to cut the semiconductor wafer 2. The laser beam radiated in the cutting step may be the same as or different from the laser beam radiated in the groove forming step. When radiating a plasma, a part or the entirety of the surface of the semiconductor wafer 2 provided with a protective film is irradiated with a plasma so that the surface of the processed groove 25 is exposed to the plasm. Hereinafter, the cutting method by plasma irradiation will be described.

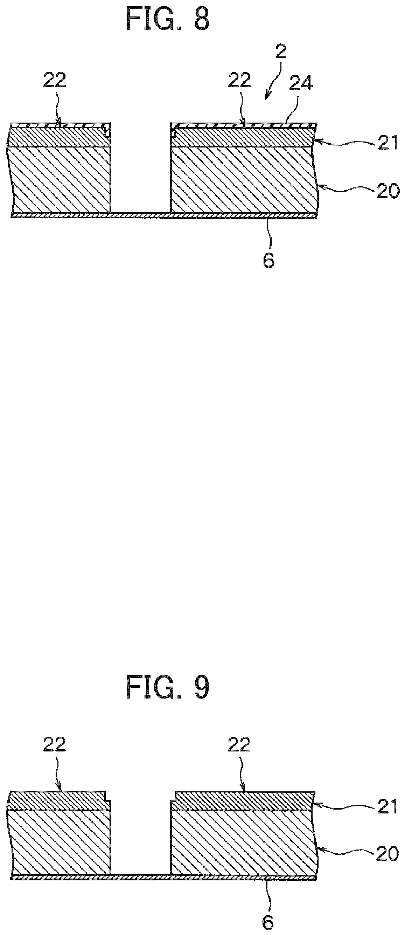

As shown in FIG. 7, the semiconductor wafer 2 including the protective film 24 and processed groove 25 is irradiated with plasma. By doing this, the position of the processed groove 25 in the semiconductor wafer 2 is cut as shown in FIG. 8. Specifically, in the semiconductor wafer 2 coated by the protective film 24, after forming the processed groove 25 as described above, the semiconductor wafer 2 is cut according to the shape of the semiconductor chips 22 by irradiating the protective film 24 and the surface 20a of the semiconductor substrate 20 exposed from the processed groove 25 with plasma to divide the semiconductor wafer 2 into the semiconductor chips 22.

The plasma irradiation conditions are not particularly limited so long as the semiconductor wafer 2 can be favorably cut at the position of the processed groove 25. The plasma irradiation conditions are appropriately set within a range of common conditions of plasma etching on the semiconductor substrate 20, considering e.g. the material of the semiconductor wafer 2, and plasma type. The gas used to generate plasma in the plasma irradiation is appropriately selected according to the material of the semiconductor wafer 2. Typically, SF₆ gas is used to generate plasma. In addition, by alternately performing sidewall protection by the supply of e.g. C₄F₆ or C₄F₈ gas, and etching of the semiconductor wafer 2 by plasma irradiation in accordance with the so-called BOSCH process, the semiconductor wafer 2 may be cut. According to the BOSCH process, etching with a high-aspect ratio is possible, and even in a case of the semiconductor wafer 2 being thick, the semiconductor wafer 2 is easily cut.

Since the protective film 24 is formed of the above-described protective film forming agent containing at least one plasticizer (C) selected from monosaccharides or disaccharides together with the water-soluble resin (A), the light absorbing agent (B), and the solvent (S), the processed groove 25 is excellent in straightness and cross-section rectangularity. Therefore, it is possible to cut a semiconductor wafer at a desired position by plasma irradiation, etc. and semiconductor chips having excellent rectilinearity can be obtained. In addition, since the protective film 24 is formed of the above-described protective film forming agent containing at least one plasticizer (C) selected from monosaccharides or disaccharides together with the water-soluble resin (A), the light absorbing agent (B), and the solvent (S), there is no crack or few cracks. For this reason, it is possible to sufficiently protect portions other than the cutting position, preventing the semiconductor substrate from being cut by plasma irradiation or the like at an undesired position (position other than the processed groove). In addition, contamination of the semiconductor substrate due to a gas such as a fluorine-based gas used in plasma irradiation can be suppressed.

Next, as shown in FIG. 9, the protective film 24 that covers the surface of the semiconductor chip 22 is removed. As described above, since the protective film 24 is formed using the protective film forming agent containing the water-soluble resin (A), the protective film 24 can be washed away by water (or warm water).

The manufacturing method of semiconductor chips by processing a semiconductor wafer has been explained above based on the embodiment as described above. The protective film forming agent and manufacturing method of semiconductor chips according to the present invention can be applied to manufacturing methods of various semiconductor chips so long as being a method including forming a protective film on the semiconductor wafer surface, and forming a processed groove at a position corresponding to a street in the surface including the protective film of the semiconductor wafer.

### EXAMPLES

The present invention will now be explained in detail by way of Examples and Comparative Examples thereof. The present invention is not limited to the following examples in any way.

### [Examples 1 to 24 and Comparative Examples 1 to 16]

In the Examples and the Comparative Examples, as the water-soluble resin (A), A1 to A4 as the water-soluble resin (A1) having an aromatic ring and a water-soluble group, A5 as the cellulose-based resin, and A6 as the polyvinyl alcohol-based resin were used. The number at the lower right of the parentheses in each constituent unit in the following structural formula represents the molar ratio of the constituent unit in each resin.

A1 is WSR-SP82 manufactured by Konishi Chemical Ind. Co., Ltd. and has a mass average molecular weight of 22,000.

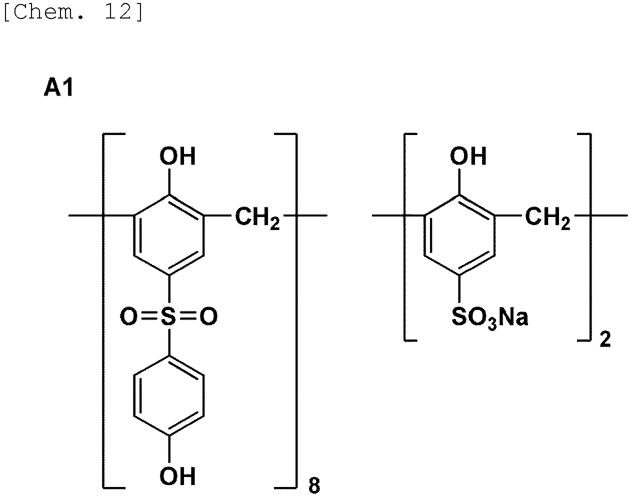

A2 is an ammonia neutralized product (pH 7) of PS-1H manufactured by Tosoh Finechem Corporation, having a mass average molecular weight of 22,000.

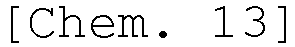

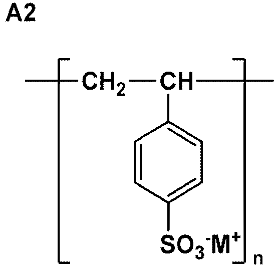

A3 was used as a solution (resin solid concentration: 14 mass%, solvent: propylene glycol monomethyl ether and water, ammonia concentration: 5 mass%) of XIRAN 3000P manufactured by POLYSCOPE. A3 has a mass average molecular weight of 10,000.

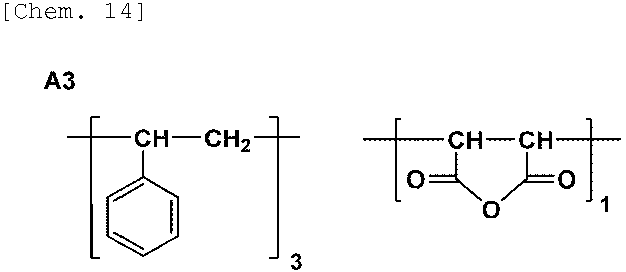

A4 is a DHDPS resin (product obtained by increasing water solubility of a reaction product of dihydroxydiphenyl sulfone (DHDPS) and formaldehyde, with phenolate ions) manufactured by Konishi Chemical Ind., having a mass average molecular weight of 1,000.

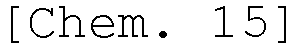

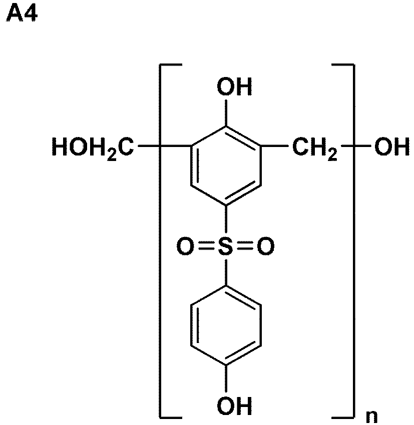

A5 is hydroxypropyl cellulose (HPC-SSL) manufactured by NIPPON SODA Co., Ltd. and has a mass average molecular weight of 25,000.

A6 is Nichigo G Polymer^{™} AZF8035W (butenediol vinyl alcohol copolymer) manufactured by Mitsubishi Chemical Corporation, having an estimated polymerization degree of 300.

In the Examples and the Comparative Examples, compound B1 represented by the following formula was used as the light absorbing agent (B).

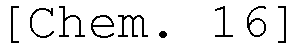

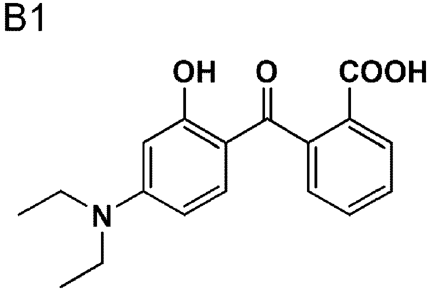

In the Examples and the Comparative Examples, compounds C1 to C10 represented by the following formulae were used as the plasticizer (C). Structures of C1 to C10 are shown below.
- C1:: D(+)-glucose
- C2:: D(+)-galactose
- C3:: D(+)-xylose
- C4:: D(-)-fructose
- C5:: D(-)-ribose
- C6:: myo-inositol
- C7:: D(+)-maltose
- C8:: trimethylolpropane
- C9:: neopentyl glycol
- C10:: polyethylene glycol

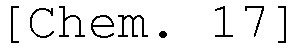

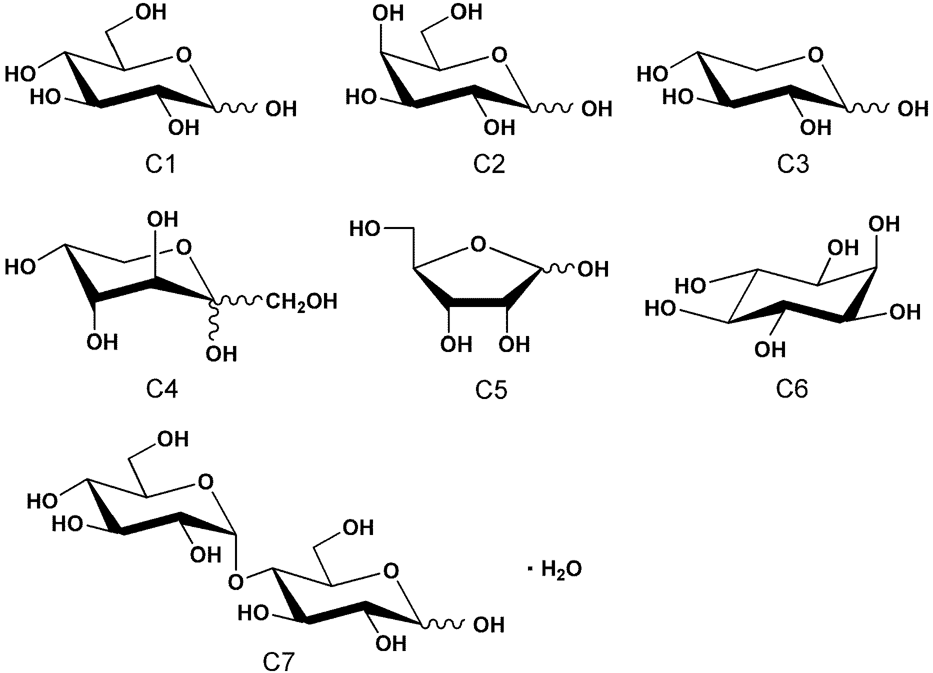

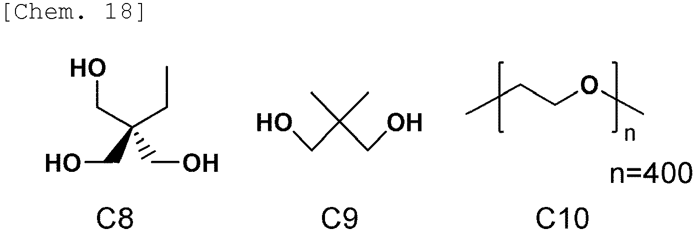

In the Examples and the Comparative Examples, monoethanolamine was used as the basic compound.

The types and parts by mass described in Tables 1 to 6 of the water-soluble resins (A), the light absorbing agent (B), the plasticizer (C), monoethanolamine as the basic compound, and the solvent (S) were added into a container so that the solvent in the protective film forming agent to be obtained has mass ratios of water 85% by mass and propylene glycol monomethyl ether 15% by mass and solid content concentrations shown in Tables 1 to 6, and stirred for 3 hours to obtain the protective film forming agents of the Examples and the Comparative Examples. The parts by mass of the water-soluble resin (A), the light absorbing agent (B), the plasticizer (C), and the monoethanolamine in the protective film forming agent to be obtained are as shown in Tables 1 to 6.

### [Evaluation of Stickiness (Tack) of Protective Film]

Each resultant protective film forming agent was applied onto a silicon substrate by a spin coating method in order for a protective film to have a thickness of 5 µm, thereby forming the coating film. Next, the coating film was naturally dried at room temperature for about 15 minutes, and the surface of the dried coating film was evaluated for whether it is sticky or not by touching it with a finger. The results are shown in Tables 1 to 6.

### [Evaluation of Cracking (Film-Forming Property) of Protective Film]

A coating film was formed in the same manner as in the above [Evaluation of Stickiness (Tack) of Protective Film]. Next, the coating film was dried under a reduced pressure to a scanning electron microscope (SEM) measurement environment (6.0 Pa), the coating film after drying under reduced pressure was observed with an optical microscope at a magnification of 10 times, and cracking (film-forming property) was evaluated by rating a case where cracks occurred as poor (indicated by cross symbol(x)), and a case where a good coating film without cracks was formed as good (indicated by circle symbol(o)). The results are shown in Tables 1 to 6.

### [Evaluation of Laser Processability (Straightness and Cross-Section Rectangularity) of Processed Groove]

The obtained protective film forming agent was applied onto a silicon substrate by a spin coating method so as to have a film thickness of 5 µm to form a coating film. After the coating film was naturally dried at room temperature for about 15 minutes, laser irradiation was linearly performed on the surface of the protective film side of the silicon substrate provided with the protective film (dried coating film) under the following conditions. The straightness and cross-section rectangularity of the processed groove were evaluated according to the evaluation criteria, to be described later, by observing the surface and the cross-sectional shape of the laser-irradiated portion of the protective film by scanning electron microscope (SEM). The SEM magnification was 100 times for straightness and 500 times for rectangularity. The results are shown in Tables 1 to 6. When cracks occurred, the laser processability was not evaluated.

### <Laser Irradiation Conditions>

Wavelength: 355 nm
Frequency: 100 kHz
Output: 0.1 W
Defocus: -0.1 mm
Feed speed: 100 mm/s
Pass: 2

### <Straightness>

Evaluation was performed according to the following criteria.
⊙ (bulleseye symbol): a straight groove (trench) having a flat cross section of the protective film (side wall of the processed groove) and being free from irregularity was formed.
○ (circle symbol): a relatively straight groove (trench) having a relatively flat cross-section of the protective film, though slightly irregular, was formed.
Δ: a groove (trench) having a cross-section of the protective film being not flat, and having large irregularity was formed.
X (cross symbol): processing defect (the pattern was softened by the heat of the laser, and the shape could not be maintained, so that a processed groove could not be formed).

### <Cross-Section Rectangularity>

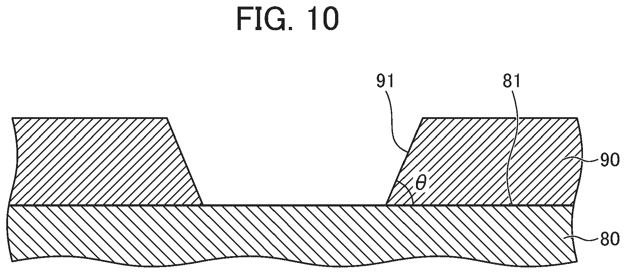

In the cross section, as shown in FIG. 10, an angle θ formed between a surface 81 of a silicon substrate 80 and a side wall 91 of a protective film 90 was measured and evaluated according to the following criteria.
⊙ (bulleseye symbol): θ is 45° or more and 90° or less.
○ (circle symbol): θ is greater than 30° and less than 45°.
Δ (triangle symbol): θ is 30° or less.
X (cross symbol): processing defect (the pattern was softened by the heat of the laser, and the shape could not be maintained, so that a processed groove could not be formed).

**[Table 1]**

| | | | Example | | | | | | | |
|---|---|---|---|---|---|---|---|---|---|---|
| | | | 1 | 2 | 3 | 4 | 5 | 6 | 7 | 8 |
| Components | Water-soluble resin (A) | A1 | 54.00 | - | - | - | 54.00 | 54.00 | 54.00 | 54.00 |
| | | A2 | - | 52.50 | - | - | - | - | - | - |
| | | A3 | - | - | 54.00 | - | - | - | - | - |
| | | A4 | - | - | - | 52.50 | - | - | - | - |
| | Light absorbing agent (B) | B1 | 10.00 | 10.00 | 10.00 | 10.00 | 10.00 | 10.00 | 10.00 | 10.00 |
| | Plasticizer (C) | C1 | 36.00 | 35.00 | 36.00 | 35.00 | - | - | - | - |
| | | C2 | - | - | - | - | 36.00 | - | - | - |
| | | C3 | - | - | - | - | - | 36.00 | - | - |
| | | C4 | - | - | - | - | - | - | 36.00 | - |
| | | C5 | - | - | - | - | - | - | - | 36.00 |
| | Basic compound | Monoethanolamine | - | 2.50 | - | 2.50 | - | - | - | - |
| | Solid concentration (% by mass) | | 35 | 35 | 25 | 35 | 35 | 35 | 35 | 35 |
| Evaluation | Film stickiness | | No | No | No | No | No | No | No | No |
| | Cracks (film forming property) | | ○ | ○ | ○ | ○ | ○ | ○ | ○ | ○ |
| | Laser processability | Straightness | ⊙ | ○ | ⊙ | ○ | ⊙ | ○ | ⊙ | ⊙ |
| | | Cross-section rectangularity | ⊙ | ○ | ⊙ | ○ | ⊙ | ○ | ⊙ | ⊙ |

**[Table 2]**

| | | | Example | | | | | |
|---|---|---|---|---|---|---|---|---|
| | | | 9 | 10 | 11 | 12 | 13 | 14 |
| Components | Water-soluble resin (A) | A1 | 45.00 | 45.00 | 45.00 | 45.00 | 45.00 | 45.00 |
| | | A5 | 18.00 | - | - | - | - | - |
| | | A6 | - | 18.00 | 18.00 | 18.00 | 18.00 | 18.00 |
| | Light absorbing agent (B) | B1 | 10.00 | 10.00 | 10.00 | 10.00 | 10.00 | 10.00 |
| | Plasticizer (C) | C1 | 27.00 | 27.00 | - | - | - | - |
| | | C2 | - | - | 27.00 | - | - | - |
| | | C3 | - | - | - | 27.00 | - | - |
| | | C4 | - | - | - | - | 27.00 | - |
| | | C5 | - | - | - | - | - | 27.00 |
| | Basic compound | Monoethanolamine | - | - | - | - | - | - |
| | Solid concentration (% by mass) | | 15 | 30 | 30 | 30 | 30 | 30 |
| Evaluation | Film stickiness | | No | No | No | No | No | No |
| | Cracks (film forming property) | | ○ | ○ | ○ | ○ | ○ | ○ |
| | Laser processability | Straightness | ⊙ | ⊙ | ⊙ | ○ | ⊙ | ⊙ |
| | | Cross-section rectangularity | ⊙ | ⊙ | ⊙ | ○ | ⊙ | ⊙ |

**[Table 3]**

| | | | Example | | | | | | |
|---|---|---|---|---|---|---|---|---|---|
| | | | 15 | 16 | 17 | 18 | 19 | 20 | 21 |
| Components | Water-soluble resin (A) | A1 | 45.00 | 45.00 | 45.00 | 45.00 | 45.00 | 45.00 | 45.00 |
| | | A6 | 36.00 | 36.00 | 36.00 | 36.00 | 36.00 | 36.00 | 36.00 |
| | Light absorbing agent (B) | B1 | 10.00 | 10.00 | 10.00 | 10.00 | 10.00 | 10.00 | 10.00 |
| | Plasticizer (C) | C1 | 9.00 | - | - | - | - | - | - |
| | | C2 | - | 9.00 | - | - | - | - | - |
| | | C3 | - | - | 9.00 | - | - | - | - |
| | | C4 | - | - | - | 9.00 | - | - | - |
| | | C5 | - | - | - | - | 9.00 | - | - |
| | | C6 | - | - | - | - | - | 9.00 | - |
| | | C7 | - | - | - | - | - | - | 9.00 |
| | Basic compound | Monoethanolamine | - | - | - | - | - | - | - |
| | Solid concentration (% by mass) | | 25 | 25 | 25 | 25 | 25 | 25 | 25 |
| Evaluation | Film stickiness | | No | No | No | No | No | No | No |
| | Cracks (film forming property) | | ○ | ○ | ○ | ○ | ○ | ○ | ○ |
| | Laser processability | Straightness | ⊙ | ⊙ | ○ | ⊙ | ⊙ | ⊙ | ⊙ |
| | | Cross-section rectangularity | ⊙ | ⊙ | ○ | ⊙ | ⊙ | ⊙ | ⊙ |

**[Table 4]**

| | | | Example | | |
|---|---|---|---|---|---|
| | | | 22 | 23 | 24 |
| Components | Water-soluble resin (A) | A2 | 43.75 | - | - |
| | | A3 | - | 45.00 | - |
| | | A4 | - | - | 43.75 |
| | | A6 | 17.50 | 18.00 | 17.50 |
| | Light absorbing agent (B) | B1 | 10.00 | 10.00 | 10.00 |
| | Plasticizer (C) | C1 | 26.25 | 27.00 | 26.25 |
| | Basic compound | Monoethanolamine | 2.50 | - | 2.50 |
| | Solid concentration(% by mass) | | 30 | 30 | 30 |
| Evaluation | Film stickiness | | No | No | No |
| | Cracks (film forming property) | | ○ | ○ | ○ |
| | Laser processability | Straightness | ○ | ⊙ | ○ |
| | | Cross-section rectangularity | ○ | ⊙ | ○ |

**[Table 5]**

| | | | Comparative Example | | | | | | | | |
|---|---|---|---|---|---|---|---|---|---|---|---|
| | | | 1 | 2 | 3 | 4 | 5 | 6 | 7 | 8 | 9 |
| Components | Water-soluble resin (A) | A1 | 90.00 | 54.00 | 54.00 | 54.00 | 54.00 | 54.00 | - | - | - |
| | | A2 | - | - | - | - | - | - | 52.50 | - | - |
| | | A3 | - | - | - | - | - | - | - | 54.00 | - |
| | | A4 | - | - | - | - | - | - | - | - | 52.50 |
| | | A5 | - | 36.00 | - | - | - | - | - | - | - |
| | | A6 | - | - | 36.00 | - | - | - | - | - | - |
| | Light absorbing agent (B) | B1 | 10.00 | 10.00 | 10.00 | 10.00 | 10.00 | 10.00 | 10.00 | 10.00 | 10.00 |
| | Plasticizer (C) | C8 | - | - | - | 36.00 | - | - | 35.00 | 36.00 | 35.00 |
| | | C9 | - | - | - | - | 36.00 | - | - | - | - |
| | | C10 | - | - | - | - | - | 36.00 | - | - | - |
| | Basic compound | Monoethanolamine | - | - | - | - | - | - | 2.50 | - | 2.50 |
| | Solid concentration (% by mass) | | 30 | 25 | 30 | 35 | 35 | 35 | 35 | 25 | 35 |
| Evaluation | Film stickiness | | No | No | No | Yes | Yes | No | No | No | No |
| | Cracks (film forming property) | | X | X | X | ○ | X | ○ | ○ | ○ | ○ |
| | Laser processability | Straightness | Not evaluated | Not evaluated | Not evaluated | X | Not evaluated | X | X | Δ | X |
| | | Cross-section rectangularity | Not evaluated | Not evaluated | Not evaluated | X | Not evaluated | X | X | Δ | X |

**[Table 6]**

| | | | Comparative Example | | | | | | |
|---|---|---|---|---|---|---|---|---|---|
| | | | 10 | 11 | 12 | 13 | 14 | 15 | 16 |
| Components | Water-soluble resin (A) | A1 | 45.00 | 45.00 | 45.00 | 45.00 | - | - | - |
| | | A2 | - | - | - | - | 45.00 | - | - |
| | | A3 | - | - | - | - | - | 45.00 | - |
| | | A4 | - | - | - | - | - | - | 43.75 |
| | | A5 | 18.00 | 18.00 | - | - | - | - | - |
| | | A6 | - | - | 18.00 | 36.00 | 18.00 | 18.00 | 17.50 |
| | Light absorbing agent (B) | B1 | 10.00 | 10.00 | 10.00 | 10.00 | 10.00 | 10.00 | 10.00 |
| | Plasticizer (C) | C8 | 27.00 | - | 27.00 | 9.00 | 27.00 | 27.00 | 26.25 |
| | | C9 | - | 27.00 | - | - | - | - | - |
| | Basic compound | Monoethanolamine | - | - | - | - | - | - | 2.50 |
| | Solid concentration (% by mass) | | 15 | 15 | 30 | 25 | 30 | 20 | 30 |
| Evaluation | Film stickiness | | No | No | Yes | No | Yes | No | No |
| | Cracks (film forming property) | | ○ | X | ○ | ○ | ○ | ○ | ○ |
| | Laser processability | Straightness | Δ | Not evaluated | Δ | Δ | x | Δ | Δ |
| | | Cross-section rectangularity | Δ | Not evaluated | Δ | Δ | X | Δ | Δ |

As shown in Tables 1 to 6, it canbe seen that by using the protective film forming agent of Examples 1 to 24 in which the protective film 24 includes the water-soluble resin (A), the light absorbing agent (B), at least one plasticizer (C) selected from monosaccharides or disaccharides, and the solvent (S), it is possible to form a protective film having excellent laser processability and suppressed occurrence of cracks. In addition, it can be seen that the protective film formed using the protective film forming agents of Examples 1 to 24 could also suppress stickiness.

### EXPLANATION OF REFERENCE NUMERALS

2 Semiconductor wafer
20 Substrate
21 Laminate
22 Semiconductor chip
23 Street
24 Protective film
25 Laser processed groove
5 Annular frame
6 Protective tape
7 Laser processing device
71 Chuck table of laser processing device
72 Laser beam irradiation means

## Claims

1. A protective film forming agent for use in forming a protective film on a surface of a semiconductor wafer in dicing the semiconductor wafer,
the protective film forming agent comprising a water-soluble resin (A), a light absorbing agent (B), at least one plasticizer (C) selected from monosaccharides or disaccharides, and a solvent (S).

2. The protective film forming agent according to claim **1,** wherein the water-soluble resin (A) comprises a water-soluble resin (A1) having an aromatic ring and a water-soluble group.

3. The protective film forming agent according to claim 2, wherein a content of the plasticizer (C) is 20 parts by mass or more and 100 parts by mass or less with regard to 100 parts by mass of the water-soluble resin (A1).

4. The protective film forming agent according to claim 2, wherein the water-soluble resin (A1) comprises a resin having a phenolic hydroxyl group.

5. The protective film forming agent according to claim 2, wherein the water-soluble resin (A) comprises a polyvinyl alcohol-based resin.

6. The protective film forming agent according to claim 1, wherein the solvent (S) comprises water.

7. A method of manufacturing a semiconductor chip by processing a semiconductor wafer, the method comprising:
forming a protective film by coating the semiconductor wafer with the protective film forming agent according to any one of claims 1 to 6, and
irradiating a predetermined position of one or more layers comprising the protective film on the semiconductor wafer with a laser beam to expose a surface of the semiconductor wafer, and to form a processed groove with a pattern according to a shape of the semiconductor chip.

8. The method of manufacturing the semiconductor chip according to claim 7, comprising cutting the semiconductor wafer at a position of the processed groove.

## Patentansprüche

1. Ein schutzfilmbildendes Mittel zur Verwendung bei der Bildung eines Schutzfilms auf einer Oberfläche eines Halbleiterwafers beim Zerteilen des Halbleiterwafers, wobei das Schutzfilmbildende Mittel ein wasserlösliches Harz (A), ein lichtabsorbierendes Mittel (B), mindestens einen Weichmacher (C), ausgewählt aus Monosacchariden oder Disacchariden, und ein Lösungsmittel (S) umfasst.

2. Das schutzfilmbildende Mittel nach Anspruch 1,
wobei das wasserlösliche Harz (A) ein wasserlösliches Harz (A1) mit einem aromatischen Ring und einer wasserlöslichen Gruppe umfasst.

3. Das schutzfilmbildende Mittel nach Anspruch 2,
wobei ein Gehalt des Weichmachers (C) 20 Massenteile oder mehr und 100 Massenteile oder weniger in Bezug auf 100 Massenteile des wasserlöslichen Harzes (A1) beträgt.

4. Das schutzfilmbildende Mittel nach Anspruch 2,
wobei das wasserlösliche Harz (A1) ein Harz mit einer phenolischen Hydroxylgruppe umfasst.

5. Das schutzfilmbildende Mittel nach Anspruch 2, wobei das wasserlösliche Harz (A) ein Harz auf Polyvinylalkoholbasis umfasst.

6. Das schutzfilmbildende Mittel nach Anspruch 1,
wobei das Lösungsmittel (S) Wasser umfasst.

7. Ein Verfahren zur Herstellung eines Halbleiterchips durch Bearbeiten eines Halbleiterwafers, wobei das Verfahren umfasst:
Bilden eines Schutzfilms durch Beschichten des Halbleiterwafers mit dem schutzfilmbildenden Mittel nach einem der Ansprüche 1 bis 6, und
Bestrahlen einer vorbestimmten Position von einer oder mehreren Schichten, die den Schutzfilm auf dem Halbleiterwafer umfassen, mit einem Laserstrahl, um eine Oberfläche des Halbleiterwafers freizulegen und eine bearbeitete Nut mit einem Muster gemäß einer Form des Halbleiterchips zu bilden.

8. Das Verfahren zur Herstellung des Halbleiterchips
nach Anspruch 7, umfassend das Schneiden des Halbleiterwafers an einer Position der bearbeiteten Nut.

## Revendications

1. Un agent de formation de film protecteur destiné à être utilisé pour former un film protecteur sur une surface d'une tranche de semi-conducteur lors du découpage de la tranche de semi-conducteur,
l'agent de formation de film protecteur comprenant une résine hydrosoluble (A), un agent absorbant la lumière (B), au moins un plastifiant (C) choisi parmi les monosaccharides ou les disaccharides, et un solvant (S).

2. L'agent de formation de film protecteur selon la revendication 1,
dans lequel la résine hydrosoluble (A) comprend une résine hydrosoluble (A1) ayant un cycle aromatique et un groupe hydrosoluble.

3. L'agent de formation de film protecteur selon la revendication 2,
dans lequel une teneur du plastifiant (C) est de 20 parties en masse ou plus et de 100 parties en masse ou moins par rapport à 100 parties en masse de la résine hydrosoluble (A1).

4. L'agent de formation de film protecteur selon la revendication 2,
dans lequel la résine hydrosoluble (A1) comprend une résine ayant un groupe hydroxyle phénolique.

5. L'agent de formation de film protecteur selon la revendication 2, dans lequel la résine hydrosoluble (A) comprend une résine à base d'alcool polyvinylique.

6. L'agent de formation de film protecteur selon la revendication 1,
dans lequel le solvant (S) comprend de l'eau.

7. Un procédé de fabrication d'une puce semi-conductrice par traitement d'une tranche de semi-conducteur, le procédé comprenant :
la formation d'un film protecteur en revêtant la tranche de semi-conducteur avec l'agent de formation de film protecteur selon l'une quelconque des revendications 1 à 6, et
l'irradiation d'une position prédéterminée d'une ou plusieurs couches comprenant le film protecteur sur la tranche de semi-conducteur avec un faisceau laser pour exposer une surface de la tranche de semi-conducteur, et pour former une rainure avec un motif selon une forme de la puce semi-conductrice.

8. Le procédé de fabrication de la puce semi-conductrice
selon la revendication 7, comprenant la découpe de la tranche de semi-conducteur à une position de la rainure.
